# EUROPÄISCHE PATENTSCHRIFT

(11) **EP 0 677 599 B1**
(45) Veröffentlichungstag und Bekanntmachung des Hinweises auf die Patenterteilung: **05.03.1997**
(21) Anmeldenummer: 95104987.3
(22) Anmeldetag: 04.04.1995
(51) Int. Cl.: C25D 5/18

(54) **Einrichtung zur Behandlung von Gegenständen, insbesondere Galvanisiereinrichtun g für Leiterplatten**
Apparatus for treatment of articles particularly for electroplating of circuit boards
Dispositif de traitement d'articles en particulier de revêtement par électrodéposition de plaques de circuits

(30) Priorität: 15.04.1994 DE 4413149
(43) Veröffentlichungstag der Anmeldung: 18.10.1995
(73) Patentinhaber: Gebr. Schmid GmbH & Co., D-72250 Freudenstadt (DE)
(72) Erfinder: Schmid, Dieter C., D-72250 Freudenstadt-Dietersweiler (DE); Schmid, Christian, D-77799 Ortenberg (DE)
(74) Vertreter: Patentanwälte Ruff, Beier, Schöndorf und Mütschele

(56) Entgegenhaltungen:
- GB-A- 946 377

## Beschreibung

Die Erfindung betrifft eine Einrichtung zur Behandlung von Gegenständen, insbesondere eine Galvanisiereinrichtung für Leiterplatten, auf einer Durchlaufbahn durch eine Behandlungskammer, mit Transportmitteln für den Transport der Gegenstände durch ein Behandlungsmedium, wie eine Elektrolytlösung, und mit Kontaktiermitteln zur elektrischen Kontaktierung und Stromzuführung von einer Stromversorgung zu den Gegenständen.

Eine solche Einrichtung ist in der DE-A-42 12 567 beschrieben. Dort werden die Gegenstände auf einer Transportbahn von Zangen erfaßt und gleichzeitig transportiert und kontaktiert. Bei einer weiteren Ausführung erfolgt eine kathodische Kontaktierung über umlaufende Walzen, die außerhalb des Behandlungsmediums über Schleifringe mit Strom versorgt werden, jedoch ihrerseits an einem umlaufenden Transportsystem geführt sind, das die Kontaktrollen mit halber Transportgeschwindigkeit der Gegenstände durch die Behandlungskammer transportiert. Auf dem Rückweg werden die Kontaktrollen mit dem entgegengesetzten Pol (anodisch) kontaktiert, so daß auf ihnen auf dem Herweg abgeschiedenes Material, z.B. Kupfer, galvanisch wieder entfernt wird.

Aufgabe der Erfindung ist es, eine Einrichtung der eingangs erwähnten Art zu schaffen, die den Stand der Technik verbessert und insbesondere die mit dem galvanischen Auftrag auf die Kontaktierungsmittel auftretenden Probleme löst.

Diese Aufgabe wird erfindungsgemäß dadurch gelöst, daß die Kontaktiermittel mehrere, wenigstens zwei, elektrisch voneinander isolierte, im Behandlungsmedium umlaufende elektrisch leitende Kontaktsektoren aufweisen, die in Umlaufrichtung abwechselnd kathodisch und anodisch an die Stromversorgung anschließbar sind. Wenn also ein Sektor mit dem Gegenstand in Kontakt ist und diese z.B. kathodisch (-) kontaktiert, dann ist mindestens ein anderer Sektor, der den Gegenstand nicht berührt, mit der entgegengesetzten Polarität beaufschlagt, beispielsweise anodisch (+). Ein galvanischer Auftrag, der auf der Kontaktfläche des entsprechenden Sektors während seiner kathodischen Kontaktierung entstanden ist, wird also dort und während einer Umdrehung des z.B. als Rolle oder Scheibe ausgebildeten Kontaktiermittels wieder abgetragen. Durch entsprechende Anordnung, beispielsweise auch durch einen relativ großen Abstand zwischen den Sektoren, kann dafür gesorgt werden, daß zwischen ihnen keine wesentliche unmittelbare elektrolytische Wirkung entsteht.

Der Anschluß der Kontaktsektoren an die Stromversorgung geschieht außerhalb der Behandlungskammer und somit außerhalb der elektrolytischen Wirkung durch abschnittsweise Stromeinleitmittel, die in ähnlicher Teilung wie die eigentlichen Kontaktsektoren Zuleitungssektoren aufweisen können, die ähnlich Kommutatoren von Elektromotoren wirken. Die Kontaktiermittel können gleichzeitig Transportmittel für die Gegenstände bilden und auch beidseitig der Transportbahn angeordnet sein, um Gegenstände auch von oben und unten gleichzeitig zu kontaktieren.

Um eine ununterbrochene Kontaktierung der Gegenstände sicherzustellen, obwohl zwischen den einzelnen Kontaktsektoren Isoliersektoren liegen, können beispielsweise mehrere Kontaktiermittel-Walzen hintereinander so dicht angeordnet sein, daß ein Gegenstand auf jeden Fall von zwei dieser Sektoren umfaßt wird. Dabei können dann die Sektoren so gegeneinander versetzt angeordnet sein, daß ein durchgehender Kontakt gewährleistet ist. Dies wäre auch innerhalb eines einzigen Kontaktmittels möglich, wenn die Sektoren einzelner in Abstand voneinander befindlicher Kontaktierscheiben gegeneinander versetzt wären und z.B. von beiden Seiten her eine entsprechend unterschiedliche Stromzuführung erfolgt. Es ist auch möglich, Abschirmmittel vorzusehen, die die Kontaktsektoren anschließend an die Kontaktstelle zum Gegenstand abdecken und damit einen Auftrag auf die Kontaktfläche vermeiden oder verringern.

Da über die Abschnitte (Segmente) der Kontaktiermittel, die anodisch beaufschlagt werden und sich dabei entmetallisieren, nur ein Teil des gesamten elektrischen Galvanisierstromes fließt und dieser möglichst aufhören sollte, wenn die Entmetallisierung beendet ist, kann durch Strom- oder Spannungsreglung in der Stromzuführung zu diesem anodisch geschalteten Abschnitt der Kontaktiermittel vermieden werden, daß Energieverluste auftreten. Dies kann sowohl durch entsprechende Spannungsanpassung, als auch durch eine zeitliche Beschränkung der Spannungszufuhr einen Teil des Umlaufes des Segmentes im äußeren Bogen oder auch durch eine aktive Regelung aufgrund von auftretenden Spannungsänderungen geschehen.

Durch die Erfindung wird eine relativ einfach aufgebaute und trotzdem wirksame Spannungszuführung insbesondere im Galvanisierungsbädern geschaffen, die auch für die Gegenstände sehr schonend arbeitet, weil die Kontaktierung abrollend erfolgt und keine Relativbewegungen oder Reibung zwischen Kontakt und Leiterplatte auftritt. Ferner gibt es durch diese Art der Kontaktierung keine toten Zonen, die nicht galvanisiert werden können, wie beispielsweise einer Zangen-Zuführung.

Die beschriebene Ausführung mit mehreren in Achsrichtung eines walzenförmigen Kontaktiermittels angeordneten Kontaktscheiben ist bevorzugt. Es wäre jedoch auch möglich, eine andere Anordnung zu wählen, beispielsweise eine durchgehende Walze. Auch eine versetzte Anordnung zwischen mehreren aufeinanderfolgenden Kontaktmitteln bzw. zu gegenüberliegenden, wäre möglich.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Ein Ausführungsbeispiel der Erfindung ist in den Zeichnungen dargestellt und wird im folgenden näher erläutert. In den Zeichnungen zeigen:
- Fig. 1: einen vertikalen Schnitt (nach der Linie I in Fig. 3) durch Kontaktiermittel, wobei in der oberen und unteren Hälfte der Figur jeweils unterschiedliche Ausführungsformen dargestellt sind,
- Fig. 2: einen Schnitt durch die Stromzuführung zu einem Kontaktmittel (nach Fig. II. in Fig. 3) und
- Fig. 3: eine Draufsicht auf einen Teil von Kontaktmitteln gemäß Fig. 1.

Die Zeichnung zeigt einen Teil einer Galvanisiereinrichtung mit einer Behandlungskammer 11, die mit einem Behandlungsmedium, beispielsweise einer Elektrolytlösung, gefüllt ist. In der langgestreckten Behandlungskammer ist eine Durchlaufbahn 12 für zu behandelnde Gegenstände 13, beispielsweise elektrische Leiterplatten, ausgebildet, die auf der horizontalen Durchlaufbahn horizontal liegend durch die Behandlungskammer 11 gefördert werden. Die Durchlaufbahn wird von Transportmitteln in Form von Transportwalzen gebildet, die gleichzeitig Kontaktmittel 15 sind, um der Oberfläche der Gegenstände 13 elektrischen Strom zuzuführen. Die Gegenstände 13 sind mit einer elektrisch leitenden Schicht 16 überzogen. Diese ist z.B. als Kupferkaschierung auf dem Basismaterial vorhanden. Die Innenflächen von Bohrungen 17 in der Leiterplatte wurden z.B. durch chemische Metallabscheidung elektrisch leitfähig gemacht.

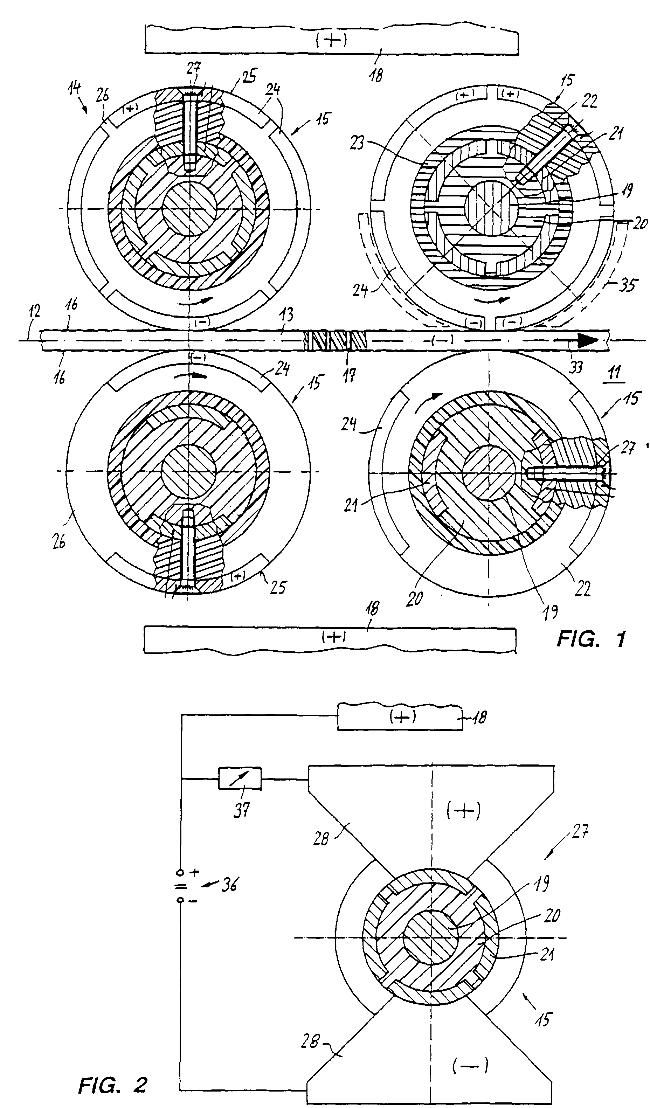

Die Aufgabe der Kontaktmittel ist es, diese Schicht 16 und damit die Außenseite der Leiterplatte elektrisch so zu kontaktieren, daß ihr Strom zugeführt wird, um einen galvanischen Prozeß durchzuführen, bei dem aus dem Elektrolyten Metall, beispielsweise Kupfer, auf den Flächen des Gegenstandes 13 einschließlich der Bohrungen abgeschieden wird. Dazu sind in der Behandlungskammer unterhalb des Spiegels des Elektrolyten Anoden 18 vorgesehen, die in Fig. 1 nur symbolisch dargestellt sind und meist aus Körben mit Kupferkugeln bestehen. Sie sind anodisch, d.h. als Pluspol, angeschlossen, während die Leiterplattenoberflächen kathodisch (als Minuspol) angeschlossen sind, so daß über den Elektrolyten Kupfer auf den Leiterplattenoberflächen und in den Bohrungen abgeschieden wird.

Die Kontaktiermittel 15, die einschließlich der Anoden gänzlich im Elektrolyten laufen, bestehen aus Walzen, die folgenden Aufbau haben: Um eine Innenwelle 19 herum ist ein Kunststoffkörper 20 angeordnet, der an seinem Außenumfang vier ringsegmentförmige Leiter 21 aufweist. Sie laufen über die gesamte Länge des walzenförmigen Kontaktmittels durch.

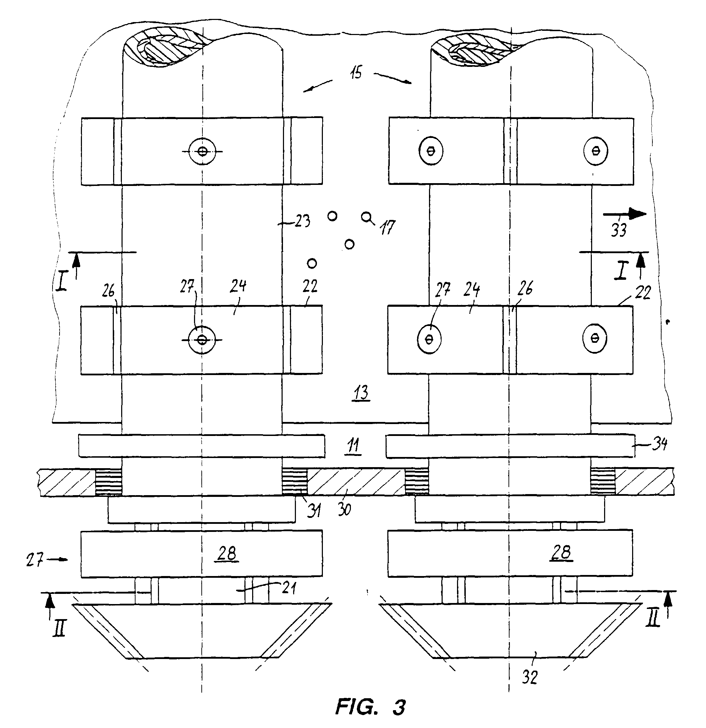

Jeweils in Abstand voneinander (s. Fig. 3) sind Scheiben 22 vorgesehen, die auf die zylindrische Außenfläche des mit den Leitersegmenten versehenen Kunststoffkörpers 20 aufgesteckt sind. Sie bestehen ebenfalls aus einem isolierenden Material, z.B. Kunststoff. Zwischen ihnen sind isolierende Distanzhülsen 23 den Kunststoffkörper umgebend vorgesehen, die somit die Abstände der Scheiben festlegen.

An ihren Außenflächen sind die Scheiben mit elektrisch leitenden Kontaktsektoren 24 versehen, die in entsprechende Ausnehmungen an der Oberfläche der Scheiben 22 eingesetzt sind, so daß ihre äußeren Kontaktflächen 25 zusammen mit den diese voneinander trennenden zur Scheibe gehörigen Isoliersektoren 26 eine durchgehende zylindrische Mantelfläche bilden. Der elektrische Anschluß der Kontaktsektoren 24 an die Leitersegmente 21 erfolgt im dargestellten Ausführungsbeispiel durch Schrauben 27, die durch die Scheibe 22 hindurch Leitersegmente 21 und Kontaktsektoren 24 verbinden und gleichzeitig eine sichere Festlegung der Scheiben gewährleisten. Die Leitersegmente 21 dienen also zur Längsleitung des Stromes innerhalb des walzenförmigen Kontaktiermittels, was auch durch andere Leitungsmittel, wie Schienen, Drähte oder dgl., erfolgen könnte. Es ist lediglich darauf zu achten, daß diese Zuleitung zum Elektrolyten hin abgeschirmt sein muß, um dort keine elektrolytischen Wirkungen auftreten zu lassen. Es ist aber auch möglich, statt der Anordnung der Segmente auf Scheiben diese durchgehend auf der Oberfläche einer Walze vorzusehen. Die Kontaktsegmente könnten darauf in geraden oder zur Achse der Walze schräggestellten Bahnen angeordnet sein.

In Fig. 1 sind jeweils oberhalb und unterhalb der Durchlaufbahn 12 zwei verschiedene Ausführungen von Kontaktiermitteln 15 gezeigt. In der oberen Hälfte hat das Kontaktiermittel vier Kontaktsektoren 24, die nur durch relativ schmale Isoliersektoren 26 voneinander getrennt sind.

Die beiden jeweils in einer Ebene liegenden Kontaktmittel 15 sind so angeordnet, daß ihre Kontaktsektoren 24 in Umfangsrichtung gegeneinander versetzt sind, im dargestellten Fall (Fig. 1 oben) um 45°.

In Fig. 1 sind in der unteren Hälfte zwei aufeinanderfolgende Kontaktmittel 15 dargestellt, die jeweils nur zwei Kontaktsektoren 24 am Umfang aufweisen, die über einen Umfangsabschnitt von mehr als 90° reichen. Zwischen ihnen ist ein relativ breiter Isoliersektor 26 vorhanden. Es sind bei im übrigen gleichem Aufbau nur zwei Leitersegmente 21 vorhanden. Der Versatz in Umfangsrichtung beträgt in diesem Falle 90°.

Fig. 2 zeigt Stromeinleitmittel 27 für eines der beiden Kontaktiermittel 15 in Fig. 1, obere Hälfte. Bei dieser Ausführungsform werden die am Außenumfang des Kunststoffkörpers 20 eingebetteten Leitersegmente 21 unmittelbar nach Art eines Kommutators von Stromzuleitungen 28, beispielsweise Kohlebürsten, sektorenweise kontaktiert. Sie leiten den Leitersegmenten 21 und damit den Kontaktsektoren 24 Strom zu, und zwar in dem Abschnitt der Kontaktmittel 15, die dem Gegenstand 12 zugewandt sind, mit negativer Polarität und in dem vom Gegenstand 13 entfernten Abschnitt mit positiver Polarität, während die dazwischen liegenden Abschnitte in der dargestellten Position nicht mit Strom versorgt werden, also neutral sind.

Die Stromzuleitungen 28 liegen außerhalb der Behandlungskammer 11, die durch eine Behandlungskammerwandung 30 begrenzt ist. Die durch diese Wandung hindurchreichenden Kontaktmittel 15 sind durch schematisch angedeutete Dichtungen 31 abgedichtet. Die Durchführungen und die Anordnung der Kontaktmittel in der Behandlungskammer sowie ihr Drehantrieb sind hier nur schematisch dargestellt. Beispielsweise kann die Lagerung der Kontaktmittel in einem besonderen Vorschubträger erfolgen, der getrennt von der Behandlungskammerwandung 30 ist, und in dieser können mehrere Dichtungen, beispielsweise Lippendichtungen, vorgesehen sein.

Die nach Art von Kohlebürsten oder anderen Schleifring-Kontakten ausgebildeten Stromzuleitungen 28 sind an eine kräftige Gleichstrom-Stromversorgung 36 angeschlossen. Dabei ist der Minuspol der Gleichstromversorgung an die kathodische Stromzuleitung zum Kontaktmittel 15 angeschlossen, während der Minuspol sowohl an die Metallisierungsanoden 18 als auch an die anodische Stromzuleitung 28 angeschlossen ist. Dieser letztere Anschluß kann über ein Steuergerät 37 erfolgen, das einen Spannungsteiler, ein Zeitglied oder eine Spannungs- bzw. Stromregelung enthalten kann. Dadurch kann erreicht werden, daß über die anodisch geschalteten Kontaktsegmente nur soviel Strom fließt, wie es zur Entmetallisierung notwendig ist. Meist reicht eine einfache Einstellung aufgrund von Erfahrungswerten, es kann aber auch eine aktive Regelung vorgesehen sein.

Zum Antrieb sind in Fig. 3 Kegelräder 32 am Ende jedes der walzenförmigen Kontaktmittel vorgesehen, die mit nicht dargestellten Kegelrädern einer durchgehenden Synchronwelle zusammenarbeiten können, so daß die Kontaktmittel synchron, jedoch in der beschriebenen Weise gegeneinander versetzt, angetrieben werden. Der Antrieb kann auch über Ketten, Riemen, Schraubenräder, und zwar außerhalb oder innerhalb der Behandlungskammer 11 erfolgen.

Die zu beiden Seiten der Durchlaufbahn 12 liegenden Kontaktmittel werden jeweils gegenläufig angetrieben, so daß sie gleichzeitig auch als Transportmittel 14 für den Gegenstand 13 dienen. Sie sollten dabei so dicht angeordnet sein, daß sie nicht nur einen möglichst gleichförmigen Transport gewährleisten, sondern auch sicherstellen, daß eine Leiterplatte möglichst mit zwei in Transportrichtung 33 aufeinanderfolgenden Kontaktmitteln in Berührung steht, um eine Stromzuführung auch dann sicherzustellen, wenn bei einem Kontaktmittel gerade ein Isoliersektor 26 an der Schicht 16 anliegt.

Auf den walzenförmigen Kontaktmitteln sind noch Abstandscheiben 34 vorgesehen, die aus Isoliermaterial bestehen und einen Druchmesser haben, der geringfügig größer ist als der der Scheiben 22. Sie verhindern, daß jeweils einander gegenüberliegende Kontaktmittel, also oberhalb und unterhalb der Durchlaufbahn, miteinander in unmittelbaren Kontakt kommen, wenn keine Leiterplatte gefördert wird. Da jedoch auf beiden Seiten gleiche Polarität vorhanden ist, wäre dies auch kein elektrisches Problem.

Man wird zweckmäßig dafür sorgen, daß zwei sich so gegenüberliegende Kontaktmittel jeweils gleiche Ausbildung und Ausrichtung haben, um beide Seiten des Gegenstandes 13 gleichmäßig zu kontaktieren und zu vermeiden, daß Strom über die leitende Beschichtung der Bohrungen von einer Seite zur anderen transportiert werden muß. Die unterschiedliche Darstellung in Fig. 1 dient nur zur Veranschaulichung unterschiedlicher Möglichkeiten der Kontaktiermittelausbildung. Die Kontaktiermittel sind in vertikaler Richtung beweglich angeordnet, zumindest die oberen, um einen guten Kontakt mit der Leiterplattenoberfläche sicherzustellen. Dies kann durch das Gewicht der oberen Kontaktmittel geschehen oder durch besondere federnde Andrückung, falls notwendig.

Die Einrichtung arbeitet nach folgendem Verfahren: Die von den Kontaktiermitteln 15 oder ggf. zusätzlich auch von anderen Transportmitteln waagerecht durch die mit Behandlungsmedium gefüllte Behandlungskammer 11 geführten Gegenstände 13 werden von den gegenläufig angetriebenen Kontaktmitteln in Transportrichtung 33 transportiert und gleichzeitig an ihrer Oberflächenschicht 16 von den Kontaktsektoren 24 kontaktiert. Diese stehen jeweils in dem dem Gegenstand 13 nahen Abschnitt mit dem Minuspol und in dem davon abgewandten Abschnitt mit dem Pluspol einer Stromversorgung in Kontakt, was durch den Ablauf der Leitersegmente 21 an den Stromzuleitungen 28 gesteuert wird. Dadurch wird auf der Oberfläche des Gegenstandes 16 und den Kontaktsektoren, soweit diese kathodisch angeschlossen sind, Metall aus dem Elektrolyten abgeschieden, während von den Anoden 18 gleichzeitig Metallionen in den Elektrolyten übergehen, diese sich also "auflösen". Gleichzeitig ist jedoch in von dem Gegenstand 13 entfernten Bereich ein Teil der Kontaktsektoren 24 ebenfalls anodisch angeschlossen, so daß auch von den Kontaktflächen 25 Metall in den Elektrolyten übergeht, und zwar dasjenige, das vorher bei kathodischer Kontaktierung darauf abgeschieden war. Diese Flächen werden also stets und unmittelbar anschließend an ihre unerwünschte Metallisierung wieder entmetallisiert. Durch entsprechende Wahl des Werkstoffes der Kontaktsektoren, z.B. Graphit, Edelstahl, Titan, Platin oder dgl., kann ein Abtrag der Kontaktsektoren selbst verhindert werden. Es ist also zu erkennen, daß durch die Erfindung die nahezu unvermeidbare galvanische Metallisierung der Kontaktierflächen unmittelbar anschließend wieder aufgehoben wird, indem während eines Umlaufs der Kontaktmittel diese Metallschicht sofort elektrolytisch wieder abgetragen und für die weitere Verwendung genutzt wird.

In Fig. 1 sind beim oberen linken Kontaktmittel 15 die oberen und unteren Kontaktflächen 24 anodisch bzw. kathodisch angeschlossen, während die rechts und links liegenden neutral sind. Bei dem daneben liegenden oberen rechten Kontaktmittel sind beide oberen Kontaktsektoren 24 anodisch und die beiden unteren kathodisch kontaktiert. Durch die relativ dichte Aufeinanderfolge der Kontaktsektoren am Umfang der Scheibe 22 ergibt sich bei jedem einzelnen Kontaktmittel eine fast lückenlose Kontaktierung.

Strichliert angedeutet sind Abschirmungen 35, die den unteren Bereich der Scheibenoberfläche 15 mit geringem Abstand umgeben und aus isolierendem Material bestehen. Die eigentliche, dem Gegenstand 13 zugewandte Kontaktfläche lassen sie frei. Sie behindern den unerwünschten Metallauftrag auf die kathodisch kontaktierten Kontaktsektoren 24. Trotzdem liegen diese Sektoren im oberen Bereich zum Abtrag eines trotzdem aufgenommenen Metallbelages frei.

Bei der in der unteren Hälfte der Fig. 3 dargestellten Ausführungsform der Kontaktmittel 15 ist ebenfalls eine lückenlose Kontaktierung vorgesehen, wenn die Leiterplatte 13 stets von zwei aufeinanderfolgenden Kontaktmitteln berührt wird. Durch die größeren Isoliersektoren 26 sind direkte elektrische Rückschlüsse zwischen den Kontaktsektoren 24 unterschiedlicher Polarität vermindert. Es ist zu erkennen, daß bei der Anordnung, Zahl und Umfangsüberdeckung der Kontaktsektoren 24 zahlreiche, den jeweiligen Gegebenenheiten angepaßte Möglichkeiten bestehen. Die Stromeinleitmittel 27 sind in ihrer Anordnung der jeweiligen Kontaktsektoranordnung anzupassen.

## Patentansprüche

1. Einrichtung zur Behandlung von Gegenständen (13), insbesondere Galvanisiereinrichtung für Leiterplatten, auf einer Durchlaufbahn (12) durch eine Behandlungskammer (11), mit Transportmitteln (14) für den Transport der Gegenstände (13) durch ein Behandlungsmedium, wie eine Elektrolytlösung, und mit Kontaktiermitteln (15) zur elektrischen Kontaktierung und Stromzuführung von einer Stromversorgung zu den Gegenständen (13), dadurch gekennzeichnet, daß die Kontaktiermittel (15) mehrere, wenigstens zwei, elektrisch voneinander isolierte, im Behandlungsmedium umlaufende elektrisch leitende Kontaktsektoren (24) aufweisen, die in Umlaufrichtung abwechselnd kathodisch und anodisch an die Stromversorgung (36) anschließbar sind.

2. Einrichtung nach Anspruch 1, dadurch gekennzeichnet, daß die Kontaktiermittel (15) umlaufende Walzen bzw. Scheiben (22) enthalten, die vorzugsweise gleichzeitig Transportmittel (14) für die Gegenstände (13) bilden.

3. Einrichtung nach Anspruch 1 oder 2, dadurch gekennzeichnet, daß die Kontaktiermittel mit einer äußeren elektrischen Isolierung versehene Walzen sind, von denen im Abstand voneinander Scheiben (22) vorstehen, auf deren Umfang die Kontaktsektoren (24) angeordnet sind, die jeweils einen Umfangsabschnitt der Scheibenoberfläche einnehmen und durch etwa auf dem gleichen Umfang liegenden Isoliersektoren (26) voneinander getrennt sind.

4. Einrichtung nach einem der vorhergehenden Ansprüche, dadurch gekennzeichnet, daß mehrere Kontaktmittel (15) in Transportrichtung (33) hintereinander angeordnet und vorzugsweise synchron angetrieben sind, die, auf die jeweilige Kontaktstelle zum Gegenstand (13) bezogen, eine von den benachbarten Kontaktmitteln abweichende Ausrichtung und/oder Aufeinanderfolge der Kontakt-Isoliersektoren (24, 26) haben.

5. Einrichtung nach einem der vorhergehenden Ansprüche, dadurch gekennzeichnet, daß jedes Kontaktmittel (15) mit den Kontaktsektoren (24) verbundene, eine den Kontaktsektoren (24) zugeordnete Sektorenkontaktierung bewirkende, außerhalb der Behandlungsflüssigkeit angeordnete abschnittsweise Stromeinleitmittel (27) aufweist.

6. Einrichtung nach einem der vorhergehenden Ansprüche, dadurch gekennzeichnet, daß je zwei Kontaktmittel beidseitig einen Gegenstand (13) kontaktieren und in einander entgegengesetzter Richtung drehend angetrieben sind und/oder durch isolierende Abstandsscheiben (34) an einer gegenseitigen Kontaktierung gehindert werden.

7. Einrichtung nach einem der vorhergehenden Ansprüche, gekennzeichnet durch Abschirmmittel (35), die die Kontaktsektoren (24) anschließend an die Kontaktstelle zum Gegenstand (13) abdecken.

## Claims

1. Apparatus for the treatment of articles (13), particularly an electroplating apparatus for circuit boards, on a continuous path (12) through a treatment chamber (11), with conveying means (14) for conveying the articles (13) through a treatment medium, such as an electrolytic solution, and with contacting means (15) for the electrical contacting and supply of current from a power supply to the articles (13), characterized in that the contacting means (15) have several and at least two electrically mutually insulated, electrically conductive contact sectors (24) revolving in the treatment medium and which in the circumferential direction can be alternately cathodically and anodically connected to the power supply (36).

2. Apparatus according to claim 1, characterized in that the contacting means (15) contain revolving rollers or disks (22), which preferably simultaneously form conveying means (14) for the articles (13).

3. Apparatus according to claim 1 or 2, characterized in that the contacting means are rollers provided with an outer, electrical insulation, from which project in spaced manner disks (22), on whose circumference are located the contact sectors (24), which in each case take up a circumferential portion of the disk surface and are separated from one another by insulating sectors (26) located on the same circumference.

4. Apparatus according to one of the preceding claims, characterized in that several contacting means (15) are successively arranged in the conveying direction (33) and are preferably synchronously driven and which, based on the particular contact point with respect to the article (13), have an orientation different from the adjacent contacting means and/or succession of contact insulating sectors (24, 26).

5. Apparatus according to one of the preceding claims, characterized in that each contacting means (15) has portionwise current introduction means (27) located outside the treatment liquid, bringing about a sector contacting associated with the contact sectors (24) and connected to said contact sectors (24).

6. Apparatus according to one of the preceding claims, characterized in that in each case two contacting means contact on both sides an article (13) and are rotated in opposite directions and/or by insulating spacing disks (34) are prevented from being in mutual contact.

7. Apparatus according to one of the preceding claims, characterized by shielding means (35), which cover the contact sectors (24) following onto the contact point with the article (13).

## Revendications

1. Dispositif de traitement d'articles (13), en particulier dispositif de revêtement de circuits imprimés par galvanoplastie, sur un chemin de passage (12) à travers une chambre de traitement (11), comportant des moyens de transport (14) pour le transport des articles (13) à travers un milieu de traitement, tel qu'une solution d'électrolyte, et des moyens de contact (15) pour réalisation d'un contact électrique et amenée de courant d'une alimentation en courant vers les articles (13), caractérisé en ce que les moyens de contact (15) présentent plusieurs, au moins deux, secteurs de contact (24) électriquement conducteurs, isolés électriquement l'un de l'autre, circulant dans le milieu de traitement, qui peuvent être raccordés dans la direction de circulation alternativement de manière cathodique et anodique à l'alimentation en courant (36).

2. Dispositif suivant la revendication 1, caractérisé en ce que les moyens de contact (15) comportent des rouleaux ou disques (22) en rotation qui, de préférence, constituent en même temps les moyens de transport (14) pour les articles (13).

3. Dispositif suivant la revendication 1 ou 2, caractérisé en ce que les moyens de contact sont des rouleaux pourvus d'une isolation électrique extérieure, desquels dépassent des disques (22) espacés l'un de l'autre, à la périphérie desquels sont disposés les secteurs de contact (24), qui occupent chacun une partie de la périphérie de la surface des disques et sont séparés l'un de l'autre par des secteurs isolants (26) situés à peu près à la même périphérie.

4. Dispositif suivant l'une des revendications précédentes, caractérisé en ce que plusieurs moyens de contact (15) sont disposés l'un derrière l'autre dans la direction de transport (33) et sont entraînés de préférence de manière synchrone, lesquels, par rapport à la zone respective de contact avec l'article (13), possèdent une orientation et/ou succession de secteurs de contact/secteurs isolants (24, 26) différant de celle des moyens de contact adjacents.

5. Dispositif suivant l'une des revendications précédentes, caractérisé en ce que chaque moyen de contact (15) présente un moyen d'amenée de courant (27) par zones, disposé en dehors du liquide de traitement, relié aux secteurs de contact (24), créant un contact par secteurs correspondant aux secteurs de contact (24).

6. Dispositif suivant l'une des revendications précédentes, caractérisé en ce que chaque fois deux moyens de contact contactent un article (13) de chaque côté et sont entraînés en rotation en sens opposés et/ou en ce que leur contact mutuel est empêché par des disques d'écartement isolants (34).

7. Dispositif suivant l'une des revendications précédentes, caractérisé en ce que des moyens de protection (35) recouvrent les secteurs de contact (24) à la suite de la zone de contact avec l'article (13).
